# EUROPEAN PATENT APPLICATION

(11) **EP 4 170 709 A1**
(43) Date of publication of application: **26.04.2023**
(21) Application number: 22196104.8
(22) Date of filing: 16.09.2022
(51) Int. Cl.: H01L 23/498, H01L 23/538

(54) **ELECTRONIC DEVICE AND METHOD OF FABRICATING ELECTRONIC DEVICE**

(30) Priority: 19.10.2021 CN 202111216366
(71) Applicant: InnoLux Corporation, Chu-Nan, Miao-Li County 35053 (TW)
(72) Inventor: TING, Chin-Lung, 35053 Chu-Nan, Miao-Li County (TW); KAO, Ker-Yih, 35053 Chu-Nan, Miao-Li County (TW); WANG, Cheng-Chi, 35053 Chu-Nan, Miao-Li County (TW); FAN, Kuang-Ming, 35053 Chu-Nan, Miao-Li County (TW); CHEN, Chun-Hung, 35053 Chu-Nan, Miao-Li County (TW); LIAO, Wen-Hsiang, 35053 Chu-Nan, Miao-Li County (TW); SHIH, Ming-Hsien, 35053 Chu-Nan, Miao-Li County (TW)
(74) Representative: Becker, Eberhard

(57) **Abstract**

An electronic device including a connection element is provided. The connection element includes a first metal layer, a first insulation layer, and a second insulation layer. The first insulation layer is disposed on the first metal layer and has a first hole and a second hole. The second insulation layer is disposed on the first insulation layer. The first hole exposes a portion of the first metal layer, and the second insulation layer extends into the second hole. A method of fabricating an electronic device is also provided.

## Description

### BACKGROUND

### Technical Field

The disclosure relates to an electronic device and a method of fabricating an electronic device.

### Description of Related Art

In the fabrication process of electronic devices, product warpage due to different physical properties of different materials, such as thermal expansion coefficients, is a problem to be overcome.

### SUMMARY

The disclosure provides an electronic device with good quality.

The disclosure provides a method of fabricating an electronic device, which may effectively reduce warpage during the fabrication process of the electronic device.

According to an embodiment of the disclosure, an electronic device includes a connection element. The connection element includes a first metal layer, a first insulation layer, and a second insulation layer. The first insulation layer is disposed on the first metal layer and has a first hole and a second hole. The second insulation layer is disposed on the first insulation layer. The first hole exposes a portion of the first metal layer, and the second insulation layer extends into the second hole.

According to an embodiment of the disclosure, a method of fabricating an electronic device is provided hereafter, which includes the following. A substrate is provided. A first metal layer is formed. A first insulation layer is formed on the first metal layer. The first insulation layer is patterned to form a first hole and a second hole. A second insulation layer is formed on the first insulation layer, in which the first hole exposes a portion of the first metal layer, and the second insulation layer extends into the second hole.

According to an embodiment of the disclosure, a method of fabricating an electronic device is provided hereafter, which includes the following. A substrate is provided. A first metal layer is formed. A first insulation layer is formed on the first metal layer. The first insulation layer is patterned to form a first opening. A second insulation layer is formed on the first insulation layer. The second insulation layer is patterned to form a second opening, in which the second opening passes through the first opening to form a through hole.

In order to make the above-mentioned features and advantages of the disclosure comprehensible, embodiments accompanied with drawings are described in detail below.

### BRIEF DESCRIPTION OF THE DRAWING

FIG. 1 is a schematic diagram of an electronic device of an embodiment of the disclosure.
FIG. 2A to FIG. 2E are schematic diagrams of some steps of a method of fabricating the electronic devices of some embodiments of the disclosure.
FIG. 3A to FIG. 3E are schematic diagrams of some steps of a method of fabricating the electronic devices of some embodiments of the disclosure.

### DETAILED DESCRIPTION OF DISCLOSED EMBODIMENTS

Reference to the exemplary embodiments of the disclosure are to be made in detail. Examples of the exemplary embodiments are illustrated in the drawings. If applicable, the same reference numerals in the drawings and the descriptions indicate the same or similar parts.

In the following description and claims, words such as "comprising" and "including" are open-ended words, so they should be interpreted as meaning "including but not limited to..."

When it is described in the disclosure that a structure (or layer, component, substrate) is located on/over a structure (or layer, component, substrate), or a structure (or layer, component, substrate) is connected to another structure (or layer, component, substrate), it may mean that the two structures are adjacent and directly connected, or may mean that the two structures are adjacent but indirectly connected. An indirect connection means that there is at least one intermediate structure (or intermediate layer, intermediate component, intermediate substrate, intermediate spacer) between the two structures. A lower surface of one structure is adjacent or directly connected to an upper surface of the intermediate structure, and an upper surface of another structure is adjacent or directly connected to a lower surface of the intermediate structure. The intermediate structure may be composed of a single-layer or multi-layer solid structure or non-solid structure, with no limitations. In the disclosure, when a certain structure is disposed "on" other structures, it may mean that the certain structure is "directly" on other structures, or it may mean that the certain structure is "indirectly" on other structures. That is, at least one structure is sandwiched between the certain structure and other structures.

Although the terms "first," "second," "third" ... may be used to describe various constituent elements, the constituent elements are not limited by the terms. The terms are only used to distinguish a single constituent element from other constituent elements in the description. The same terms may not be used in the claim, but replaced by first, second, third... according to the order in which the elements are declared in the claim. Therefore, the first constituent element in the following description may be the second constituent element in the claim.

As used herein, the terms "about," "approximately," "substantially," and "generally" generally mean within 10%, within 5%, within 3%, within 2%, within 1%, or within 0.5% of a given value or range. The quantity given here is an approximate quantity. That is, even though "about," "approximately," "substantially," and "generally" are not specified, the meanings of "about," "approximately," "substantially," and "generally" are still implied. Furthermore, the terms "range from a first value to a second value", and "range between a first value to a second value" mean that the range includes the first value, the second value, and other values in between.

The electrical connection or coupling described in the disclosure may refer to direct connection or indirect connection. In the case of a direct connection, the end points of two elements on a circuit are directly connected to each other, or connected to each other through a conductive wire. In the case of an indirect connection, a switch, a diode, a capacitor, an inductor, a resistor, other suitable elements, or a combination thereof, but not limited thereto, is arranged between the end points of two elements on a circuit.

In the disclosure, the thickness, length, and width may be measured by adopting a measurement method such as an optical microscope, and the thickness may be measured from a cross-sectional image in an electronic microscope, but not limited thereto. In addition, any two values or directions used for comparison may have certain errors. If a first value is equal to a second value, it implies that there may be an error of about 10%, 5%, or 3% between the first value and the second value.

It should be noted that, in the following embodiments, the features in several different embodiments may be dismantled, replaced, reorganized, and mixed to complete other embodiments without departing from the spirit of the disclosure. As long as the features of the various embodiments do not violate the spirit of the disclosure or conflict with one another, they may be mixed and combined arbitrarily.

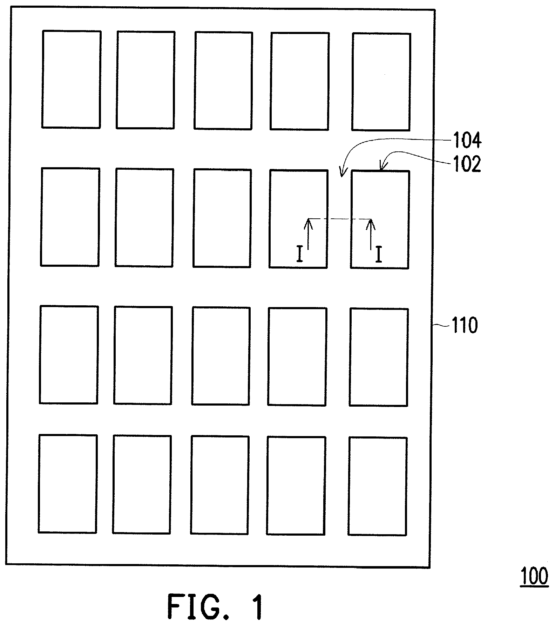

FIG. 1 is a schematic diagram of an electronic device of an embodiment of the disclosure. An electronic device 100 has multiple element regions 102 and a non-element region 104. The element regions 102 are arranged in an array and separated from one another, and the non-element region 104 is distributed between the element regions 102. In some embodiments, at least a chip, a wiring layer and a packaging material may be disposed in the element region 102. The chip may be a light emitting chip, a semiconductor chip, and the like. In some embodiments, the semiconductor chip may define electronic circuits composed of active elements, passive elements, or a combination thereof, such as a logic circuit, a memory circuit, and the like. In some embodiments, the electronic device 100 may be a high frequency element, a light emitting element, a packaging element, and the like. The non-element region 104 may include a cutting line, and the electronic device 100 may be cut along the cutting line to obtain multiple independent electronic devices. In some embodiments, after cutting, the structure of the non-element region 104 may partially remain in the independent electronic device, or may not exist in the independent electronic device.

In some embodiments, the electronic device 100 may be supported by a substrate 110. In addition, required connection elements may be fabricated on the substrate 110 to realize the electrical connection relationship required by each of the components. The connection element here may be understood as a re-distribution layer (RDL), but not limited thereto. The substrate 110 may be a glass substrate, a silicon substrate, a sapphire substrate, and the like, and has a panel-level size. For example, the substrate 110 may be a G3.5 generation glass substrate with a size of about 610 mm × 720 mm, but not limited thereto. In other embodiments, the substrate 110 may be a G3 generation glass substrate, a G4 generation glass substrate, a G4.5 generation glass substrate, a G5 generation glass substrate, a G5.5 generation glass substrate, or a newer generation glass substrate. In this embodiment, for example, a chip may be attached to a panel-level substrate, or a re-distribution layer may be fabricated on the panel-level substrate and the chip may be packaged. Therefore, this embodiment may be used as an application for a fan out panel-level package (FOPLP), in which the fan out panel-level package includes a chip first process and a re-distribution layer first (RDL first) process. Since the fan out panel-level package adopts a panel-level substrate 110, the production capacity may be greatly improved compared to a wafer-level package. Meanwhile, the panel-level substrate 110 has a rectangular outline, which may greatly improve the utilization rate of the substrate 110 compared to a wafer-level package. Therefore, the electronic device 100 may be configured to realize high productivity requirements.

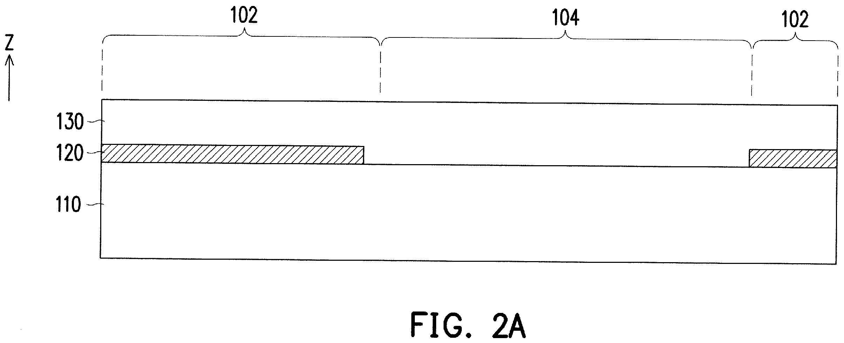

FIG. 2A to FIG. 2E are schematic diagrams of some steps of a method of fabricating the electronic devices of some embodiments of the disclosure. The structures shown in FIG. 2A to FIG. 2E correspond to the cross-section of a line I-I in FIG. 1, but the method of fabricating the electronic device is not limited thereto. In FIG. 2A, a first metal layer 120 is formed on the substrate 110 and a first insulation layer 130 is formed on the first metal layer 120. The first metal layer 120 may be distributed in the element region 102 to establish the required electrical transmission paths in the element region 102. In some embodiments, the method of fabricating the first metal layer 120 may include forming a metal material on the substrate 110 and patterning the metal material to form the first metal layer 120. The method of patterning the metal material may include lithography etching, electroplating, or other alternative methods. The method of fabricating the first insulation layer 130 may be forming an insulating material on the substrate 110, so that the insulating material covers the first metal layer 120 and the substrate 110. The first insulation layer 130 may cover 70 percent or more of the area of the substrate 110. In some embodiments, the first insulation layer 130 may cover 80 percent or more of the area of the substrate 110. Alternatively, in other embodiments, the first insulation layer 130 may cover 90 percent or more of the area of the substrate 110. Therefore, the first insulation layer 130 may continuously extend on the non-element region 104 between adjacent element regions 102, but not limited thereto. In some embodiments, the insulating material of the first insulation layer 130 includes, for example, a photosensitive material, such as photosensitive polyimide (photosensitive PI), but not limited thereto. The thickness of the first insulation layer 130 may be controlled to provide a substantially flat top surface. For example, the roughness of the top surface of the first insulation layer 130 is less than or equal to 1 micrometer (µm), but not limited thereto. According to some embodiments, the portion of the first insulation layer 130 overlapping the first metal layer 120 may be thinner than the portion not overlapping the first metal layer 120, but the disclosure is not limited thereto.

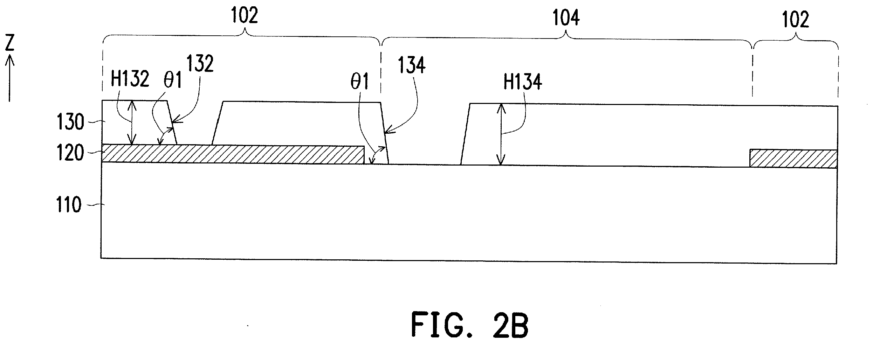

In FIG. 2B, the first insulation layer 130 is then patterned to form a first hole 132 and a second hole 134. The first hole 132 is located in the element region 102 and exposes a portion of the first metal layer 120, and the second hole 134 is located in the non-element region 104 or adjacent to the non-element region 104, but not limited thereto. The method of patterning the first insulation layer 130 includes lithography etching. In this embodiment, the first insulation layer 130 may have positive photosensitive properties. The method of patterning the first insulation layer 130 includes, for example, an exposing step, a developing step, and a curing step. In the exposing step, a photomask is used to irradiate the insulating material at the first hole 132 and the second hole 134 by radiation while the remaining insulating material is not irradiated by radiation. The developing step is, for example, contacting the first insulation layer 130 with a developer, in which the exposed insulating material may be removed by the developer, while the unexposed insulating material is not easily removed by the developer and thus remains. Therefore, the insulating material at the first hole 132 and the second hole 134 is removed after the developing step to form the first hole 132 and the second hole 134. Next, in the curing step, thermal curing or other suitable curing steps may be adopted to cure the first insulation layer 130 having the first hole 132 and the second hole 134, so that the first insulation layer 130 has a stable and firm structure.

In some embodiments, a height H132 of the first hole 132 on the first metal layer 120 may be less than a height H134 of the second hole 134 not on the first metal layer 120, but the disclosure is not limited thereto. For example, a height of a hole may be similar to a thickness of the insulation layer. In addition, the photosensitive material may form a steep sidewall after being patterned by lithography. For example, an angle θ1 between the sidewall of the second hole 134 and the bottom surface of the first insulation layer 130 may be greater than 75 degrees and less than or equal to 90 degrees. Meanwhile, the first hole 132 may also have a similarly steep sidewall.

The angle, thickness, length, and width may be measured by adopting a measurement method such as an optical microscope, and the angle and thickness may be measured from a cross-sectional image in an electronic microscope, but not limited thereto. In addition, any two values or directions used for comparison may have certain errors. If a first value is equal to a second value, it implies that there may be an error of about 10% between the first value and the second value; if a first direction is perpendicular to a second direction, an angle between the first direction and the second direction may be between 80 degrees and 100 degrees; if the first direction is parallel to the second direction, an angle between the first direction and the second direction may be between 0 degrees and 10 degrees. The first direction referred to in the disclosure is the Z direction or a normal direction of the electronic device, which is the direction in which the insulation layers and the metal layers are alternately stacked, and the height is measured along the Z direction.

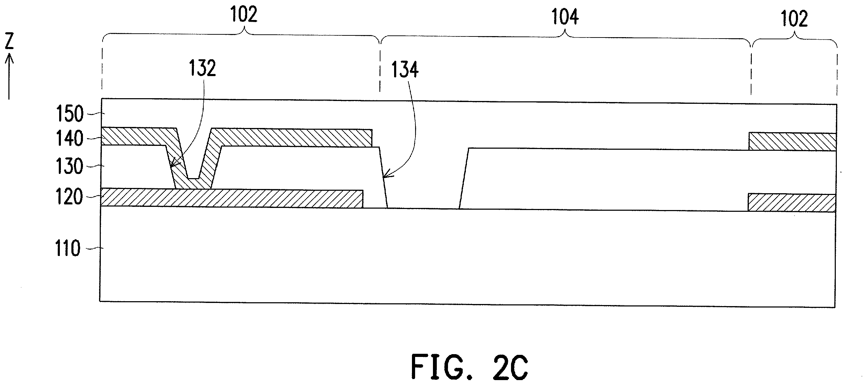

In FIG. 2C, a second metal layer 140 and a second insulation layer 150 are successively formed on the first insulation layer 130. The method of fabricating the second metal layer 140 is generally similar to the method of fabricating the first metal layer 120, and the layout of the second metal layer 140 may be different from the layout of the first metal layer 120 to realize the required electrical transmission paths. At least a portion of the second metal layer 140 is disposed in the first hole 132 and is electrically connected to the first metal layer 120 through the first hole 132. The manner of forming the second insulation layer 150 is generally similar to the manner of forming the first insulation layer 130. The second insulation layer 150 covers the second metal layer 140 and covers the first insulation layer 130 outside of the second metal layer 140, so the second metal layer 140 is disposed between the first insulation layer 130 and the second insulation layer 150. In addition, the second insulation layer 150 may extend into the second hole 134 of the first insulation layer 130 to contact the substrate 110 under the first insulation layer 130. The material of the second insulation layer 150 may be similar or the same as that of the first insulation layer 130. For example, the material of the second insulation layer 150 may include a photosensitive material, such as photosensitive polyimide (photosensitive PI), but not limited thereto.

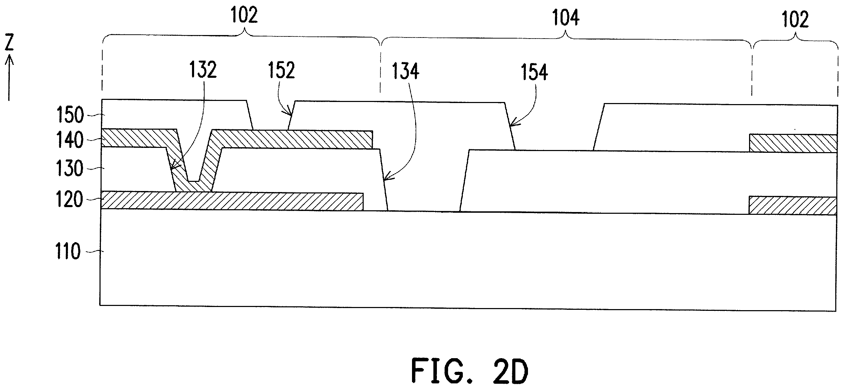

In FIG. 2D, the second insulation layer 150 is patterned to form a third hole 152 and a fourth hole 154. In some embodiments, the insulating material of the second insulation layer 150 has positive photosensitive properties, and the method of patterning the second insulation layer 150 may be similar to the method of patterning the first insulation layer 130. The third hole 152 is, for example, located in the element region 102, and the fourth hole 154 is, for example, located in the non-element region 104. The third hole 152 may expose a portion of the second metal layer 140 to provide a path for the second metal layer 140 and a subsequently formed metal layer to be electrically connected to each other. The fourth hole 154 does not overlap with the second hole 134, so the second insulation layer 150 still extends into the second hole 134 of the first insulation layer 130 after being patterned.

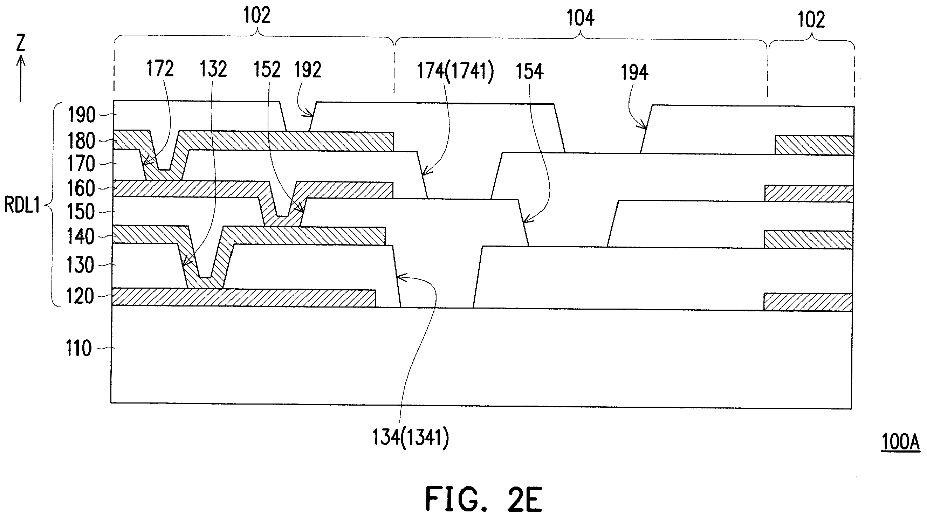

FIG. 2E shows that a third metal layer 160, a third insulation layer 170, a fourth metal layer 180, and a fourth insulation layer 190 are sequentially formed on the second insulation layer 150 after the step of FIG. 2D to form a connection element RDL1 of an electronic device 100A. The method of fabricating the third metal layer 160 and the fourth metal layer 180 are generally similar to the foregoing method of fabricating the first metal layer 120 and the second metal layer 140, and the method of fabricating the third insulation layer 170 and the fourth insulation layer 190 are generally similar to the foregoing method of fabricating the first insulation layer 130 and the second insulation layer 150. For example, the third metal layer 160 and the fourth metal layer 180 are generally disposed in the element region 102, and the third insulation layer 170 and the fourth insulation layer 190 respectively cover the third metal layer 160 and the fourth metal layer 180. The third metal layer 160 may extend into the third hole 152 of the second insulation layer 150 that exposes the second metal layer 140, and the third insulation layer 170 may extend into the fourth hole 154 of the second insulation layer 150 that exposes a portion of the first insulation layer 130. The third insulation layer 170 may be patterned to have a fifth hole 172 that exposes a portion of the third metal layer 160 and a sixth hole 174 that exposes a portion of the second insulation layer 150. The fourth metal layer 180 may extend into the fifth hole 172 of the third insulation layer 170 that exposes a portion of the third metal layer 160, and the fourth insulation layer 190 may extend into the sixth hole 174 of the third insulation layer 170 that exposes a portion of the second insulation layer 150. In addition, the fourth insulation layer 190 may be selectively patterned to have similar holes, such as a seventh hole 192 and an eighth hole 194.

In FIG. 2E, the electronic device 100A includes the connection element RDL1, in which the connection element RDL1 includes the first metal layer 120, the first insulation layer 130, the second insulation layer 150, and other multi-layer metal layers and multi-layer insulation layers. In some embodiments, the connection element may include thin film transistor electrically connected to at least one of the multi-layer metal layers, but not limited thereto. The first insulation layer 130 is disposed on the first metal layer 120 and has the first hole 132 and the second hole 134. The second insulation layer 150 is disposed on the first insulation layer 130. The first hole 132 exposes a portion of the first metal layer 120, and the second insulation layer 150 extends into the second hole 134. The connection element RDL1 may be configured as a wiring layer of the element to provide the required conductive transmission paths. Specifically, in the connection element RDL1, the number of layers of the metal layer and the insulation layer may be adjusted according to the required wiring plan, but FIG. 2E is illustrated by taking four metal layers and four insulation layers as an example.

The first metal layer 120, the second metal layer 140, the third metal layer 160, and the fourth metal layer 180 are respectively covered by the first insulation layer 130, the second insulation layer 150, the third insulation layer 170, and the fourth insulation layer 190. The first insulation layer 130, the second insulation layer 150, the third insulation layer 170, and the fourth insulation layer 190 are each patterned to have holes. In each of the first insulation layer 130, the second insulation layer 150, the third insulation layer 170, and the fourth insulation layer 190, some holes, such as the first hole 132, the third hole 152, the fifth hole 172, and the seventh hole 192, that exposes a portion of the underlying metal layer, may be filled by a metal layer above. In each of the first insulation layer 130, the second insulation layer 150, the third insulation layer 170, and the fourth insulation layer 190, some holes, such as the second hole 134, the fourth hole 154, the sixth hole 174, and the eighth hole 194, that exposes a portion of the underlying insulation layer, may be filled by an insulation layer above. For example, the fourth hole 154 exposes a portion of the first insulation layer 130. In details, the second hole 134 includes a side surface 1341, the sixth hole 174 includes a side surface 1741. In some embodiments, the side surface 1341 may be a side surface of the first insulation layer 130, the side surface 1741 may be a side surface of the third insulation layer 170, and the side surface 1741 is not overlapped with the side surface 1341 along the Z direction. Similarly, at least a side surface of the fifth hole 172 is not is not overlapped with a side surface of the first hole 132 along the Z direction. In details, a center of the second hole 134 may be located in a manner of laterally shifted with respective to a center of the sixth hole 174, and similarly, a center of the first hole 132 may be located in a manner of laterally shifted with respective to a center of the fifth hole 172. In other words, the center of the second hole 134 may not be aligned with the center of the sixth hole 174 in the Z direction and the center of the first hole 132 may not be aligned with the center of the fifth hole 172 in the Z direction. According to above design, the insulation layers may become flat, a risk of broken of the metal layers disposed on the insulation layers will be decreased and the reliability of the electronic device may be increased, but not limit to.

The first hole 132, the third hole 152, the fifth hole 172, and the seventh hole 192 may allow electrical connection between different metal layers. In this way, the first metal layer 120, the second metal layer 140, the third metal layer 160, and the fourth metal layer 180 may establish the conductive transmission paths of the electronic device 100A. The second hole 134, the fourth hole 154, the sixth hole 174, and the eighth hole 194 may be configured as buffer structures. For example, due to the disposition of the second hole 134, the fourth hole 154, the sixth hole 174, and the eighth hole 194, the stress caused by changes in temperature, pressure, and the like during the process of fabricating the electronic device 100A is released so that warpage of the substrate 110 does not easily occur. Therefore, the electronic device 100A may maintain good flatness during the fabricating process, which facilitates in ensuring the accuracy of the patterning step and improving the process yield, electrical characteristics or reliability.

In some embodiments, when fabricating the electronic device 100A, the disposition positions of the second hole 134, the fourth hole 154, the sixth hole 174, and the eighth hole 194 may be predetermined. In some embodiments, the disposition positions of the second hole 134, the fourth hole 154, the sixth hole 174, and the eighth hole 194 may be adjusted according to the actual device state. For example, the overall flatness of the device may be inspected before each of the insulation layers is fabricated, and the deposition positions of the second hole 134, the fourth hole 154, the sixth hole 174, and the eighth hole 194 are then decided according to the inspection result. For example, before fabricating the insulation layer, an automated optical inspection (AOI) system may be adopted to inspect the overall flatness of the device. The second hole 134, the fourth hole 154, the sixth hole 174, and the eighth hole 194 may be disposed in the positions where the inspection result shows warpage or warpage that is relatively serious. For example, the automated optical inspection system determines that the warpage is greater than or equal to 25 µm as the position where the warpage is relatively serious, but not limited thereto. Through the above-mentioned determination and immediate correction, inaccurate positioning, uneven film thickness, and the like due to the warpage of the structure are less likely to occur in the subsequent steps. In some embodiments, if there is no obvious warpage and deformation state in the flatness inspection result, the corresponding insulation layer may not form holes for buffering and only provides holes for electrical conduction. In other words, in some embodiments, one or more of the second hole 134, the fourth hole 154, the sixth hole 174, and the eighth hole 194 may be omitted.

The disposition positions of the second hole 134, the fourth hole 154, the sixth hole 174, and the eighth hole 194 may be at least staggered from the holes of the adjacent layers. That is, the fourth hole 154 may not overlap the second hole 134 or the sixth hole 174, and the sixth hole 174 may not overlap the fourth hole 154 or the eighth hole 194. Therefore, the second hole 134, the fourth hole 154, the sixth hole 174, and the eighth hole 194 are all filled with the insulation layer above, so that these holes are not connected to one another. In addition, although FIG. 2E shows that the second hole 134, the fourth hole 154, the sixth hole 174, and the eighth hole 194 are located close to one another, in actuality the deposition positions of the second hole 134, the fourth hole 154, the sixth hole 174, and the eighth hole 194 may be scattered. In addition, the sizes of the second hole 134, the fourth hole 154, the sixth hole 174, and the eighth hole 194 may also be adjusted according to the flatness inspection result, but not limited thereto. In other words, the sizes of the second hole 134, the fourth hole 154, the sixth hole 174, and the eighth hole 194 may be the same or different from one another, or at least partially different from one another. The sizes referred to in the disclosure include width, height, or shape, but not limited thereto. In addition, according to some embodiments, the side edges of the second hole 134 and the sixth hole 174 do not overlap along the Z direction.

In addition, although not shown, the electronic device 100A may further include electronic elements, such as semiconductor chips. The semiconductor chip may be disposed on the substrate 110 and electrically connected with the connection element RDL1. In some embodiments, the connection element RDL1 may also include a-Si thin film transistor or IGZO thin film transistor which is electrically connected with the electronic elements, but not limited thereto. The semiconductor chip may be attached to the substrate 110 after the connection element RDL1 is fabricated, that is, fabricated by adopting the RDL first method of fabrication. In some embodiments, the semiconductor chip may be attached to the substrate 110 before the connection element RDL1 is fabricated, that is, fabricated by adopting a chip first method of fabrication. In some embodiments, the semiconductor chip disposed on the substrate 110 may be a die-packaged die. The electronic device 100A may thus also include a packaging material that is not shown, such as a molding compound, and the packaging material packages the semiconductor chip.

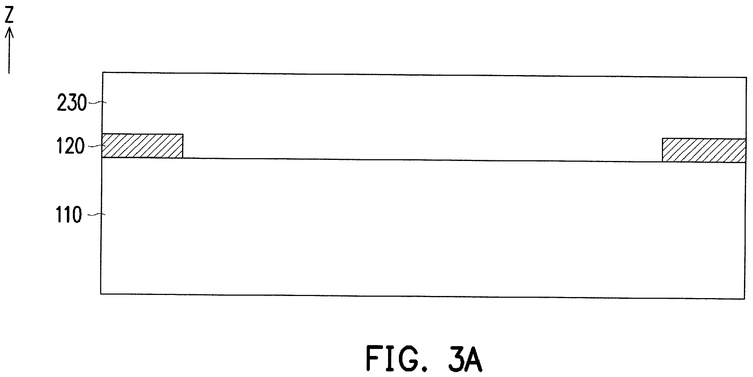

FIG. 3A to FIG. 3E are schematic diagrams of some steps of a method of fabricating the electronic devices of some embodiments of the disclosure. The structures shown in FIG. 3A to FIG. 3E correspond to the cross-section of the electronic device along the line I-I in FIG. 1, but the method of fabricating the electronic device is not limited thereto. In FIG. 3A, the first metal layer 120 and a first insulation layer 230 are formed on the substrate 110. Here, the steps of forming the first metal layer 120 and the first insulation layer 230 are generally similar to the steps of FIG. 2A. However, the material of the first insulation layer 230 includes, for example, a photosensitive insulating material with negative photosensitive properties, such as polyimide with negative photosensitive properties.

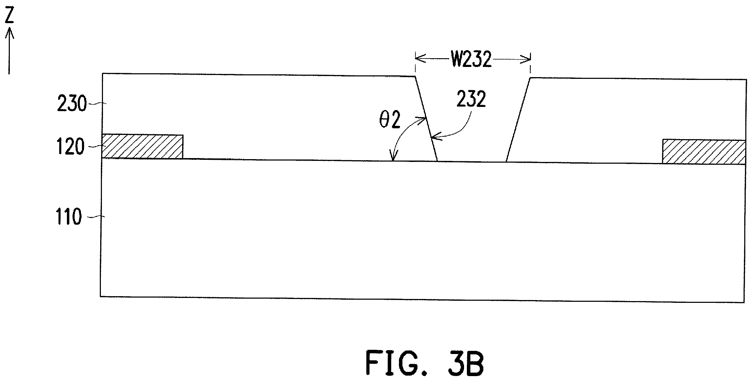

In FIG. 3B, the first insulation layer 230 is then patterned by lithography to form a first opening 232. The lithography used to pattern the first insulation layer 230 may use a photomask to perform an exposing step such that the insulating material at the first opening 232 is shielded and the insulating material outside the first opening 232 is irradiated by radiation. After that, a developing step is performed, in which the material of the first insulation layer 230 contacts the developer, so that the insulating material not irradiated by radiation is removed, and the insulating material irradiated by radiation remains. Then, a curing step is performed to completely cure the remaining insulating material to form the first insulation layer 230 having the first opening 232. The first opening 232 is formed by lithography and may have a steep sidewall. For example, an angle θ2 between the sidewall of the first opening 232 and the bottom surface of the first insulation layer 230 may be greater than 75 degrees and less than or equal to 90 degrees, but not limited thereto. In addition, a width W232 of the first opening 232 is, for example, greater as the distance from the substrate 110 along the Z direction increases. That is, the first opening 232 may have an inverted trapezoidal outline.

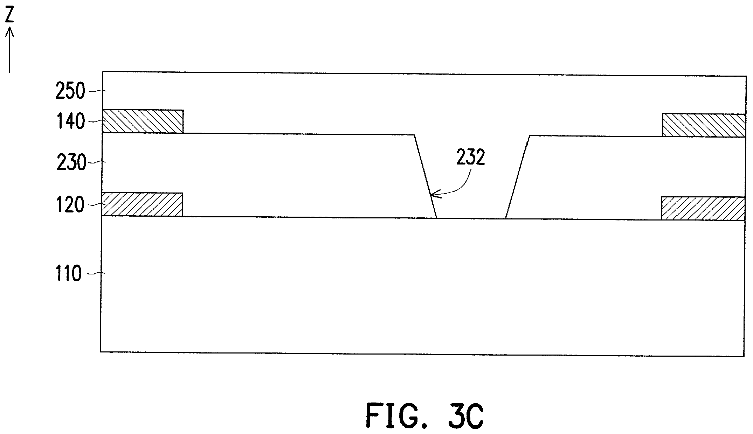

In FIG. 3C, the second metal layer 140 and a second insulation layer 250 are sequentially formed on the first insulation layer 230. For the method of forming the second metal layer 140, reference may be made to the foregoing embodiments. In addition, although not shown in FIG. 3B, in the lithography step of forming the first opening 232, holes for exposing a portion of the first metal layer 120 may be formed together, and the second metal layer 140 may contact the first metal layer 120 through such holes to realize electrical connection between different metal layers. The second insulation layer 250 may be entirely formed on the substrate 110 to cover the second metal layer 140 and the first insulation layer 130.

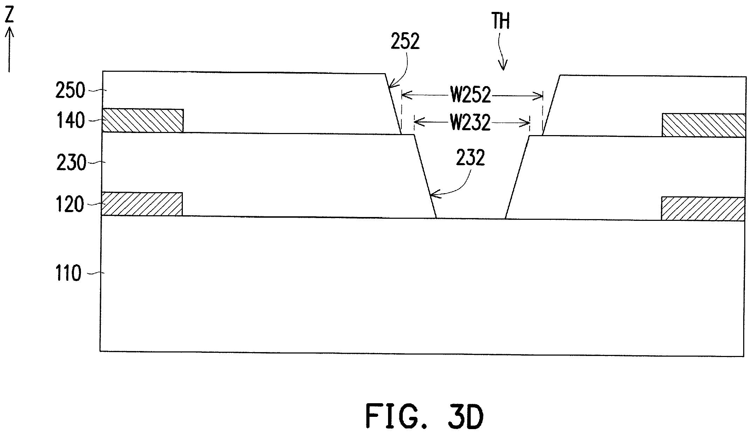

Then, in FIG. 3D, the second insulation layer 250 is patterned to form the second opening 252, in which the material of the second insulation layer 250 may have negative photosensitive properties and may be patterned in a manner similar to that of the first insulation layer 230. The second opening 252 may pass through the first opening 232 to form a through hole TH. A width W252 of the second opening 252 may be greater than the width W232 of the first opening 232 so that the first opening 232 is completely exposed. For example, the width W252 of the second opening 252 at the narrowest part may be greater than the width W232 of the first opening 232 at the widest part.

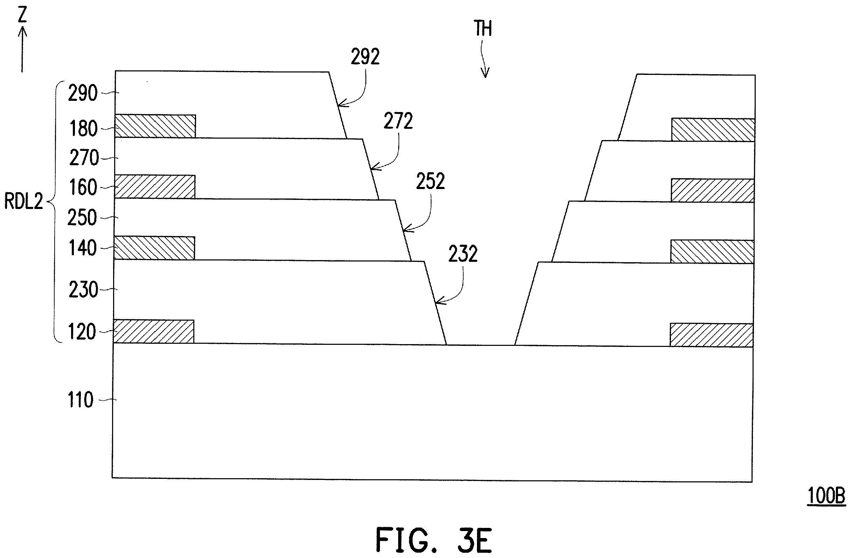

FIG. 3E shows that the third metal layer 160, the third insulation layer 270, the fourth metal layer 180, and the fourth insulation layer 290 are sequentially formed on the second insulation layer 250 to form a connection element RDL2 of an electronic device 100B, in which the connection element RDL2 may be configured as a wiring layer to realize the required electrical transmission paths. In this embodiment, for the method of fabricating the third metal layer 160 and the fourth metal layer 180, reference may be made to the foregoing embodiments, and the method of fabricating the third insulation layer 270 and the fourth insulation layer 290 may be similar to that of the first insulation layer 230 and the second insulation layer 250. The third insulation layer 270 may be patterned to have a third opening 272, and the fourth insulation layer 290 may be patterned to have a fourth opening 292. The third opening 272 passes through the first opening 232 and the second opening 252, and the fourth opening 292 passes through the first opening 232, the second opening 252, and the third opening 272 to form the through hole TH. In this way, the through hole TH may expose a portion of the substrate 110. The outline of the through hole TH is, for example, a stepped shape, and the size of the through hole TH is wider as the distance from the substrate 110 increases. According to some embodiments, at least two of the side edge of the first opening 232, the side edge of the second opening 252, the side edge of the third opening 272, and the side edge of the fourth opening 292 do not overlap along the Z direction. Through the above-mentioned design, the warpage of the electronic device 100A may be reduced.

The first opening 232, the second opening 252, the third opening 272, and the fourth opening 292 may be configured as buffer structures. For example, due to the disposition of the first opening 232, the second opening 252, the third opening 272, and the fourth opening 292, the stress caused by changes in temperature, pressure, and the like during the process of fabricating the electronic device 100B is released so that warpage of the substrate 110 does not easily occur. Therefore, the electronic device 100B may maintain good flatness during the fabricating process, which facilitates in ensuring the accuracy of the patterning step and improving the process yield.

To sum up, the electronic device and the method of fabricating the electronic device according to the embodiments of the disclosure may disconnect the insulation layers in the connection element to provide buffering. Therefore, the electronic device is not easily warped due to the stress in the fabricating process, which facilitates in improving the fabricating yield of the electronic device.

## Claims

1. An electronic device (100A), comprising:
a connection element (RDL1), comprising:
a first metal layer (120);
a first insulation layer (130), disposed on the first metal layer (120) and having a first hole (132) and a second hole (134); and
a second insulation layer (150), disposed on the first insulation layer (130), wherein
the first hole (132) exposes a portion of the first metal layer (120), and the second insulation layer (150) extends into the second hole (134).

2. The electronic device according to claim 1, wherein the connection element (RDL1) further comprises a second metal layer (140), disposed between the first insulation layer (130) and the second insulation layer (150), and the second metal layer (140) is electrically connected to the first metal layer (120) through the first hole (132).

3. The electronic device according to claim 2, wherein the second insulation layer (150) has a third hole (152) and a fourth hole (154), the third hole (152) exposes a portion of the second metal layer (140), and the fourth hole (154) does not overlap with the second hole (134).

4. The electronic device according to claim 3, wherein the connection element (RDL1) further comprises a third insulation layer (170), disposed on the second insulation layer (150), and the third insulation layer (150) extends into the fourth hole (154).

5. The electronic device according to claim 1, wherein in a cross-section, a height (H132) of the first hole (132) is less than a height (H134) of the second hole (134).

6. The electronic device according to claim 1, wherein an angle (θ1) between a sidewall of the second hole (134) and a bottom surface of the first insulation layer (130) is greater than 75 degrees and less than or equal to 90 degrees.

7. A method of fabricating an electronic device (100A), comprising:
providing a substrate (110);
forming a first metal layer (120);
forming a first insulation layer (130) on the first metal layer (120);
patterning the first insulation layer (130) to form a first hole (132) and a second hole (134); and
forming a second insulation layer (150) on the first insulation layer (130), wherein
the first hole (132) exposes a portion of the first metal layer (120), and the second insulation layer (150) extends into the second hole (134).

8. The method of fabricating an electronic device according to claim 7, wherein patterning the first insulation layer (130) comprises performing lithography.

9. The method of fabricating an electronic device according to claim 7, further comprising patterning the second insulation layer (150) to form a third hole (152) and a fourth hole (154), wherein the third hole (152) exposes a portion of the second metal layer (140), and the fourth hole (154) does not overlap with the second hole (134).

10. The method of fabricating an electronic device according to claim 9, wherein patterning the second insulation layer (150) comprises exposing a portion of the first insulation layer (130) with the fourth hole (154).

11. A method of fabricating an electronic device (100B), comprising:
providing a substrate (110);
forming a first metal layer (120);
forming a first insulation layer (230) on the first metal layer (120);
patterning the first insulation layer (230) to form a first opening (232);
forming a second insulation layer (250) on the first insulation layer (230); and
patterning the second insulation layer (250) to form a second opening (252), wherein the second opening (252) passes through the first opening (232) to form a through hole (272).

12. The method of fabricating an electronic device according to claim 11, wherein before patterning the second insulation layer (250), the second insulation layer (250) extends into the first opening (232).

13. The method of fabricating an electronic device according to claim 11, wherein patterning the first insulation layer (230) and the second insulation layer (250) comprises performing lithography.

14. The method of fabricating an electronic device according to claim 11, wherein patterning the second insulation layer (250) comprises forming a width (W252) of the second opening (252) to be greater than a width (W232) of the first opening (232).

15. The method of fabricating an electronic device according to claim 11, wherein patterning the second insulation layer (250) comprises forming a side edge of the second opening (252) not to be overlapped with a side edge of the first opening (232).
